# EUROPÄISCHE PATENTANMELDUNG

(11) **EP 1 223 431 A2**
(43) Veröffentlichungstag der Anmeldung: **17.07.2002**
(21) Anmeldenummer: 02000394.3
(22) Anmeldetag: 07.01.2002
(51) Int. Cl.: G01R 31/26

(54) **Vorrichtung zur Fehlerfeststellung einer Photovoltaikanlage**

(30) Priorität: 13.01.2001 DE 10106908; 21.12.2001 EP 01130550
(71) Anmelder: Otronic GmbH & Co. KG, 59939 Olsberg (DE)
(72) Erfinder: Schulte, Franz Josef, 59939 Olsberg (DE)
(74) Vertreter: WALTHER, WALTHER & HINZ Patentanwälte

(57) **Zusammenfassung**

Gegenstand der Erfindung ist eine Vorrichtung zur Fehlerfeststellung einer Photovoltaikanlage mit einem photoelektrischen Einstrahlungssensor, wobei sowohl die Photovoltaikanlage (PV-Anlage), als auch der Einstrahlungssensor an einer Auswerteeinheit angeschlossen sind, wobei der Auswerteeinheit durch die PV-Anlage und den Einstrahlungssensor zumindest zu einem, vorzugsweise zu mehreren gleichen Zeitpunkten innerhalb eines bestimmten Zeitraumes ein der momentanen Einstrahlung entsprechender Leistungswert übermittelt wird, wobei durch die Auswerteeinheit ein Nominalwert N1 aus dem Verhältnis (Quotienten) der beiden Leistungswerte gebildet wird, wobei korrespondierend zu den jeweiligen Nominalwerten N1 zu gleichen Zeitpunkten innerhalb des gleichen, späteren Zeitraumes weitere Nominalwerte N2 ermittelt werden, wobei durch Mittelwertbildung aus den beiden Nominalwerten N1 und N2 ein korrigierter Nominalwert NK bestimmt wird, wobei bei Über- oder Unterschreiten dieser korrigierten Nominalwerte NK durch korrespondierend zu den Nominalwerten N2 zum jeweils gleichen Zeitpunkt innerhalb eines gleichen, späteren Zeitraumes ermittelten Nominalwerte N3 ein Signal, zum Beispiel eine Fehlermeldung, durch die Auswerteeinheit generiert wird.

## Beschreibung

Die vorliegende Erfindung betrifft eine Vorrichtung zur Fehlerfeststellung einer Photovoltaikanlage mit einem photoelektrischen Einstrahlungssensor, wobei sowohl die Photovoltaikanlage (PV-Anlage), als auch der Einstrahlungssensor an einer Auswerteeinheit angeschlossen sind.

Photovoltaikanlagen sind bekannt; derartige Photovoltaikanlagen sind häufig aus verschiedenen Strings zusammengesetzt, d. h., dass mehreren PV-Modulen jeweils ein Wechselrichter zugeordnet ist. Da die PV-Anlagen häufig an Stellen angeordnet, die nur schwer zugänglich sind, beispielsweise auf Dächern und auch gegebenenfalls in einiger Entfernung zu demjenigen, der für die Überwachung der PV-Anlage zuständig ist, ist so ohne Weiteres nicht erkennbar, ob eine PV-Anlage ordnungsgemäß funktioniert oder nicht. So kann es sein, dass beispielsweise ein Wechselrichter ausfällt, was zu einem erheblichen Verlust an Leistungsausbeute führt.

Aus dem Stand der Technik sind diverse Verfahren zur Fehlerfeststellung einer Solaranlage bekannt. So ist beispielsweise aus dem Bulletin SEV/VSE 10/94 Seite 27 ein Konzept für eine Überwachungseinrichtung zur Ertragssicherung einer Photovoltaikanlage bekannt, bei dem eine laufende Kontrolle der produzierten Leistung anhand der solaren Einstrahlung, der Zellentemperatur und der eingespeisten Netzleistung erfolgt. Hierbei wird eine Sollleistung errechnet und mit dem Istwert verglichen. Bei Abweichungen, die einen zulässigen Wert überschreiten, wird eine Störungsmeldung akustischer oder optischer Art ausgelöst.

Ein ähnliches System ist aus der Zeitschrift TR TRANSFER Nr. 14 · 1996, Seite 38/39 bekannt; auch hier wird der Tagessollwert mit der tatsächlich gemessenen Energiemenge des Tagesistwertes verglichen. Liegt nun die Tagesproduktion außerhalb des Toleranzbereiches der Sollproduktion, so wird ebenfalls eine Störungsmeldung generiert, was allerdings mindestens einen Tag benötigt. Bei einer 100 KW Anlage kostet der Ausfall der Anlage allerdings bis zu DM 600,--/Tag

Ein ähnliches Verfahren zur Fehlerfeststellung bei einer Solaranlage ist auch aus der DE 198 16 139 A1 bekannt; bei diesem Verfahren werden die Leistungswerte eines photoelektrischen Sensors mit denen der Photovoltaikanlage verglichen, wobei dann, wenn das Ausgangssignal des photoelektrischen Sensors eine vorbestimmte Schwelle überschreitet und der vom Strommessgerät gemessene Strom eine vorbestimmte Schwelle unterschreitet, ein Fehlersignal generiert wird.

Nachteilig bei all diesen Verfahren ist, dass die spezifischen Bedingungen, unter denen Photovoltaikanlagen arbeiten, so z. B. ungleichmäßige Ausrichtung der PV-Anlagen und andere äußere Einflüsse, nicht genügend berücksichtigt werden. Die Folge hiervon ist, dass Fehlermeldungen generiert werden, obwohl die Photovoltaikanlage fehlerfrei arbeitet. Erfahrungsgemäß lässt dann, wenn in einer kurzen Zeitspanne eine Vielzahl von Fehlermeldungen generiert werden, obwohl ein Fehler im eigentlichen Sinn nicht vorliegt, die Aufmerksamkeit der Überwachungs-person nach, so dass dann, wenn tatsächlich ein Fehler in der Anlage vorliegt, beispielsweise dann, wenn ein Wechselrichter ausfällt, dieses erst zu spät bemerkt wird. Solche ungerechtfertigten Fehlermeldungen treten bei den bekannten Verfahren zur Fehlerfeststellung insbesondere dann auf, wenn äußere Einflüsse auf die PV-Anlage einwirken, die über einen Schwellwert hinaus zu einer Leistungseinbuße führen. Dies kann beispielsweise dadurch geschehen, dass bei einer bestimmten Sonnenstellung ein Teil der PV-Anlage abgeschattet wird, während der photoelektrische Sensor nicht abgeschattet wird.

Insofern liegt der Erfindung die Aufgabe zu Grunde, eine Vorrichtung der eingangs genannten Art bereitzustellen, die wesentlich flexibler arbeitet, und insbesondere auch in der Lage ist, Abweichungen in der Leistungsausbeute einer PV-Anlage zu berücksichtigen, die nicht in einer technisch fehlerhaften Anlage begründet sind.

Die Aufgabe wird nach einer ersten Variante dadurch gelöst, dass der Auswerteeinheit durch die PV-Anlage und durch den photoelektrischen Einstrahlungssensor zumindest zu einem gleichen Zeitpunkt ein der momentanen Einstrahlung entsprechender Leistungswert übermittelt wird, wobei durch die Auswerteeinheit ein Nominalwert N1 aus dem Verhältnis (Quotient) der beiden Leistungswerte gebildet wird, wobei bei Über- oder Unterschreiten dieses zu einem bestimmten Zeitpunkt ermittelten Nominalwertes N1 durch den zum gleichen Zeitpunkt innerhalb eines bestimmten nachgeordneten (späteren) Zeitraumes ermittelten Nominalwertes N2 ein Signal, z.B. eine Fehlermeldung, durch die Auswerteeinheit generiert wird. Im Einzelnen ist hierbei vorgesehen, dass beispielsweise in bestimmten zeitlichen Abständen, z.B. 10 min., über einen Zeitraum von 24 h jeweils die entsprechenden Nominalwerte N1 durch die Auswerteeinheit ermittelt werden. Diese Nominalwerte N1 berücksichtigen bereits Differenzen in der Einstrahlung zwischen Einstrahlungssensor einerseits und PV-Anlage andererseits, und stellen somit im Prinzip korrigierte Werte dar, die, so hat sich ergeben, durchaus realistische Werte für die Leistungsfähigkeit einer PV-Anlage darstellen. Weicht dann der zum jeweils gleichen Zeitpunkt innerhalb eines späteren Zeitraumes, also z.B. dem nächsten Tag, ermittelte Nominalwert N2 von diesem Nominalwert N1 ab, dann wird eine Fehlermeldung durch die Auswerteeinheit generiert. Die beschriebene Vorrichtung ist zugegebenermaßen noch sehr empfindlich, ist aber wirkungsvoll insbesondere in Regionen einzusetzen, bei denen Tag für Tag die gleichen Bedingungen vorherrschen wie dies beispielsweise in südlichen Gegenden, z.B. im Bereich des Äquators der Fall ist.

Eine Vorrichtung zur Fehlerfeststellung einer Photovoltaikanlage, die weniger empfindlich ist und die demzufolge auch in Breitengraden eingesetzt werden kann, in denen durchaus unterschiedliche Wetterbedingungen und auch unterschiedliche Einstrahlungswerte über die Jahreszeit erreicht werden, zeichnet sich erfindungsgemäß dadurch aus, dass der Auswerteeinheit durch die PV-Anlage und den Einstrahlungssensor zumindest zu einem, vorzugsweise jedoch zu mehreren gleichen Zeitpunkten innerhalb eines bestimmten Zeitraumes ein der momentalen Einstrahlung entsprechender Leistungswert übermittelt wird, wobei durch die Auswerteeinheit ein Nominalwert N1 aus dem Verhältnis (Quotient) der beiden Leistungswerte gebildet wird, wobei korrespondierend zu den jeweiligen Nominalwerten N1 zu gleichen Zeitpunkten innerhalb des gleichen, späteren Zeitraumes weitere Nominalwerte N2 ermittelt werden, wobei durch Mittelwertbildung aus den beiden Nominalwerten N1 und N2 ein korrigierter Nominalwert NK bestimmt wird, wobei bei Über- oder Unterschreiten dieser korrigierten Nominalwerte NK durch korrespondierend zu den Nominalwerten N2 zum jeweils gleichen Zeitpunkt innerhalb eines gleichen, späteren Zeitraumes ermittelte Nominalwerte N3 ein Signal, z.B. eine Fehlermeldung durch die Auswerteeinheit generiert wird. Diese weitere Vorrichtung zeichnet sich also dadurch aus, dass durch die Mittelwertbildung zwischen dem letzten Nominalwert und dem aktuellen Nominalwert ein jeweils korrigierter Nominalwert bestimmt wird, der - je häufiger über einen bestimmten Zeitraum diese Mittelwertbildung erfolgt - die tatsächlichen Einstrahlungsgegebenheiten immer genauer widerspiegelt. Das heißt, man nähert sich iterativ einem Optimum an. Nach Erreichen des vermeintlichen Optimums, was nach wenigen Tagen der Fall sein kann, ist die Lernphase abgeschlossen. Die Mittelwertbildung erfolgt vorteilhaft unter Berücksichtigung des aktuellen Nominalwertes und des letzten Nominalwertes, wobei dieser letzte Nominalwert auch ein bereits durch Mittelwertbildung ermittelter korrigierter Nominalwert sein kann. Somit kann durch die zuvor beschriebene Vorrichtung zur Fehlerfeststellung einer PV-Anlage zwar die Fehlerhaftigkeit einer Anlage festgestellt werden, wenn z.B. ein Wechselrichter ausfällt, jedoch führen Unterschiede in den Leistungswerten der PV-Anlage, die aufgrund ihrer Größe und Ausrichtung, beispielsweise eine nicht unbedingt optimale Stellung zur Sonne einnehmen kann, und die demzufolge keine hundertprozentige Leistungsausbeute zu einem bestimmten Zeitpunkt eines Zeitraumes, also beispielsweise von 24 h erwarten lässt, nicht zu einer Fehlermeldung. Dies im Gegensatz zu Leistungseinbußen aufgrund von Fehlern in der Anlage selbst. Eine solche Verminderung der Leistungsausbeute, die allerdings nicht in der Fehlerhaftigkeit der Anlage begründet ist, kann beispielsweise auch dadurch hervorgerufen werden, dass eine derartige PV-Anlage durch einen Schornstein abgeschattet wird, ein Baum die Einstrahlung behindert, die Ausrichtung wegen der Dachkonstruktion teilweise nicht optimal ist oder andere Widrigkeiten zu einer Leistungseinbuße führen. Weitere vorteilhafte Merkmale sind den üblichen Unteransprüchen zu entnehmen.

Eine weitere Optimierung der vorgesehenen Vorrichtung erfolgt vorteilhaft dadurch, dass den über einen bestimmten Zeitraum ermittelten Nominalwerten ein Toleranzbereich zugeordnet wird. Dies geschieht im einfachsten Fall dadurch, dass der Toleranzbereich willkürlich vorgegeben wird oder aber dadurch, dass sich der Toleranzbereich aus der Bandbreite bestimmt, in der sich ein bestimmter Prozentsatz, z.B. 90 % der Nominalwerte befindet. Hieraus wird deutlich, dass die Nominalwerte zum einen dadurch optimiert werden, dass eben der jeweilige Nominalwert aus dem Quotienten vom jeweiligen Leistungswert der PV-Anlage und Leistungswert des Einstrahlungssensors ermittelt wird, und zum anderen in einer optimierten Version dadurch, dass die ermittelten Nominalwerte durch Mittelwertbildung weiterhin optimiert werden, wobei in beiden Fällen die weitere Optimierung durch die Zuordnung eines bestimmten Toleranzbereiches zu den einzelnen Nominalwerten erfolgt. Eine Fehlermeldung wird somit nicht bei Überschreitung gewisser absoluter Werte generiert, sondern lediglich bei Überschreitung relativer Werte.

Der Grundgedanke, der der Erfindung zu Grunde liegt, besteht demzufolge darin, die Vorgaben des photoelektrischen Einstrahlungssensors, der die gleiche Lage wie die PV-Anlage einnehmen sollte, durch die tatsächlichen Leistungswerte der PV-Anlage zu korrigieren, die auf Grund ihrer Größe und Ausrichtung beispielsweise nicht unbedingt eine Stellung zur Sonne einnehmen kann, die eine 100 %-ige Leistungsausbeute zu einem bestimmten Zeitpunkt eines Zeitraumes, also beispielsweise 24 Stunden, erwarten lässt. Dies kann darin begründet sein, dass eine derartige PV-Anlage durch beispielsweise einen Schornstein abgeschattet wird, ein Baum die Einstrahlung behindert, die Ausrichtung wegen der Dachkonstruktion teilweise nicht optimal ist oder andere Widrigkeiten zu einer Leistungseinbuße führen, die allerdings nicht in einem Mangel der PV-Anlage als solcher begründet sind.

Wesentlich ist, dass die Ermittlung der Leistungswerte der PV-Anlage an der Übergabestelle zum Netz erfolgt. Es werden demzufolge nicht einzelne Komponenten der Anlage überprüft, wie dies teilweise im Stand der Technik der Fall ist, sondern durch die Ermittlung der Leistungswerte an der Übergabestelle zum Netz oder am Einspeisezähler die Anlage insgesamt.

Vorteilhaft werden der Einstrahlungssensor und die PV-Anlage thermisch abgeglichen, was insbesondere durch direkte mechanische Kopplung der beiden Teile erfolgt. Die gemeinsame Temperatur erfasst ein Temperaturfühler im Einstrahlungssensor.

Sind Einstrahlungssensor und PV-Anlage an unterschiedlichen Orten untergebracht, dann kann es dazu kommen, dass allein auf Grund der größeren spezifischen Oberfläche die PV-Anlage kälter ist, als der Einstrahlungssensor. Insofern ist dann ein Abgleich zwischen PV-Anlage und Einstrahlungssensor erforderlich, da die PV-Anlage auf Grund der geringeren Temperatur eine höhere spezifische Leistung abgeben wird, als der Einstrahlungssensor. Die Kompensation oder Korrektur erfolgt durch die Auswerteeinheit.

Nach einem weiteren vorteilhaften Merkmal der Erfindung steht die Vorrichtung zur Fehlerfeststellung einer PV-Anlage also die Auswerteeinheit mit einer Anzeige in Verbindung, beispielsweise einem Display. Die Verbindung erfolgt vorteilhaft über Funk, so dass auch weitere Entfernungen problemlos überbrückt werden können. Dies gilt im Übrigen auch für den Einstrahlungssensor, dessen Daten ebenfalls über Funk abgerufen werden können.

Die Auswerteeinheit kann demzufolge die Leistungswerte des Einstrahlungssensors über Funk oder herkömmlich durch Leitungsverbindung erhalten.

Des Weiteren ist vorgesehen, dass die Auswerteeinheit einen Speicher umfasst, der die Daten der PV-Anlage speichert, um in einem Monatsund/oder Jahresvergleich Aussagen über die Funktionsfähigkeit und Funktionstüchtigkeit der PV-Anlage treffen zu können.

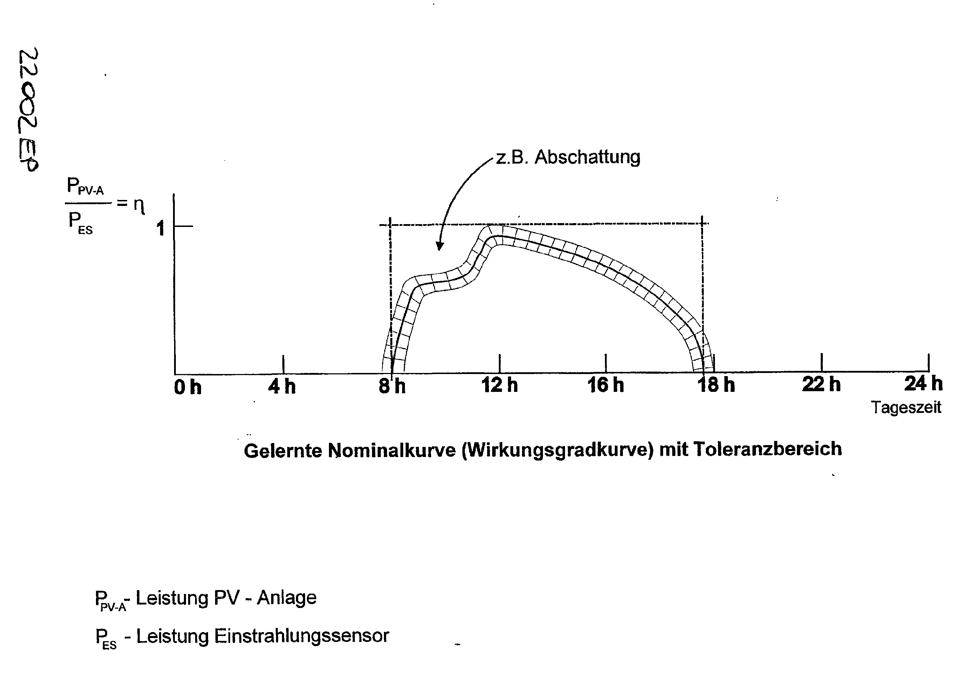

Anhand der Zeichnung sowie der Beschreibung der Lern- und Betriebsphase wird die Erfindung nachstehend näher erläutert.

Bei dem Betrieb der Vorrichtung sind zwei Phasen zu unterscheiden:

### 1. LERNPHASE

Dazu wird ermittelt und abgespeichert:
- Datum und Uhrzeit
- Leistungswert aus dem Einstrahlungssensor (ES)
- Leistungswert aus der PV-Anlage (PV-A)

Vorgehensweise:
In der Auswerteeinheit werden die beiden Werte aus ES und PV-A zusammen mit der Uhrzeit und Datum über einen bestimmten Zeitraum von z. B. zwei vollen Tagen mit mindestens 30 % solarer Einstrahlung gespeichert. Die Abtastung kann z. B. im 4 Min. Intervall erfolgen.

Das Datenmaterial wird derart ausgewertet, dass pro Wertepaar aus PV-A und ES der Quotient gebildet wird, d. h. pro Stunde 15 Quotienten. Diese Quotienten entsprechen dem Wirkungsgrad der PV-Anlage, bezogen auf den Wert des Einstrahlungssensors. Da die Einstrahlungssensoren kalibriert sind, ergeben sich vergleichsweise präzise Ergebnisse.

An beiden Tagen werden die Wirkungsgradwerte zu zeitgleichen Abtastpunkten ermittelt und als Basis für den gültigen Toleranzbereich verwendet. Das heißt, dass insbesondere aus der Bandbreite, in der sich ein bestimmter Prozentsatz von Nominalwerten, beispielsweise 90 % der Nominalwerte, befindet, der Toleranzbereich bestimmt, das heißt vorgegeben wird.

Im Idealfall bilden die Wirkungsgradpunkte über der Leistung aufgetragen eine Gerade (siehe Zeichnung). Tatsächlich sinkt der Wirkungsgrad bei niedrigen Leistungen, da die Wechselrichterverluste bei niedriger Leistungsabgabe der PV-Anlage stärker wirksam werden, als bei erhöhter Leistungsabgabe. Diese Lernphase, in der über einen bestimmten Zeitraum lediglich Quotienten aus den Leistungswerten der PV-Anlage und des Einstrahlungssensors gebildet werden und gegebenenfalls diesen Nominalwerten ein Toleranzbereich zugeordnet wird, wird abgeschlossen durch Eingriff des Benutzers von außen. Eine Optimierung der Leistungsgradkurve erfolgt nun dadurch, dass über mehrere Zeiträume hinweg Nominalwerte ermittelt werden, wobei hierbei durch Mittelwertbildung der in einem Zeitraum ermittelten Nominalwerte mit den korrespondierenden Nominalwerten eines nachfolgenden Zeitraumes, sogenannte korrigierte Nominalwerte (NK) bestimmt werden, die somit die Abweichung in der Sonneneinstrahlung zweier Zeiträume berücksichtigen. Auch diese korrigierten Nominalwerte (NK) können wiederum durch Mittelwertbildung mit den jeweils aktuellen Nominalwerten eines Zeitraumes korrigiert werden, so dass sich im Rahmen einer solchen Lernphase iterativ eine den tatsächlichen Verhältnissen relativ genau entsprechende Wirkungsgradkurve ergibt. Zu einem bestimmten Zeitpunkt muss diese Lernphase abgeschlossen werden, wobei dann, wenn diese Nominalwerte (NK) durch nachfolgende Nominalwerte unter- oder überschritten werden, eine Fehlermeldung generiert wird (siehe Zeichnung).

Eine weitere Optimierung dieser Wirkungsgradkurve erfolgt durch die Zuordnung eines Toleranzbereiches, der entweder willkürlich bestimmt wird, oder aber der sich, wie bereits erläutert, aus der Bandbreite ergibt, in der ein bestimmter Prozentsatz der ermittelten Nominalwerte sich befindet. Natürlich ist die Auswerteeinheit derart ausgebildet, dass in die Lernphase bei Bedarf immer wieder eingestiegen werden kann, so dass über einen längeren Zeitraum hinweg die ganze Vorrichtung optimiert werden kann.

### 2. BETRIEBSPHASE

Eine gelernte und akzeptierte Wirkungsgradkurve mit dem Toleranzbereich über einen bestimmten Zeitraum der solaren Einstrahlung ist nun der Bereich, in dem die reale PV-Anlage ohne Fehlermeldung arbeiten soll. Sobald der Toleranzbereich für eine definierte Zeit, zum Beispiel 30 min. verlassen wird, löst die Auswerteeinheit ein Fehlersignal aus. Aus der Größe des Fehlersignales, das heißt aus der Größe der Abweichung des aktuellen Nominalwertes von dem Toleranzbereich bzw. dem entsprechenden Nominalwert N bzw. NK der Wirkungsgradkurve kann auf die Schwere des Fehlers (Teilausfall, Komplettausfall) geschlossen werden und entsprechend kodierte Fehlersignale abgesetzt werden. Ständige kleine Abweichungen in eine Richtung (je nach Jahreszeit) werden registriert und verschieben die Kurve mit dem Toleranzbereich zu den verschiedenen Zeitpunkten entsprechend. Das heißt, dass sich die Brandbeite verschiebt, in der ein bestimmter Prozentsatz der Nominalwerte sich befindet. Eine derartige Verschiebung kann - wie bereits ausgeführt - ständig registriert werden und den Toleranzbereich entlang der eigentlichen Wirkungsgradkurve verschieben. Hierdurch können z. B. Abschattungen, die durch den Verlauf der Sonne von Tag zu Tag zu- oder abnehmen, berücksichtigt werden.

Die Fehlermeldung bei Wirkungsgradänderungen zum positiven Bereich sind notwendig, um ggf. die Funktion des Einstrahlungssensors prüfen zu können (z. B. Abdeckung durch Blätter, Schmutz oder dgl.).

## Patentansprüche

1. Vorrichtung zur Fehlerfeststellung einer Photovoltaikanlage mit einem photoelektrischen Einstrahlungssensor, wobei sowohl die Photovoltaikanlage (PV-Anlage), als auch der Einstrahlungssensor an einer Auswerteeinheit angeschlossen sind,
**dadurch gekennzeichnet,**
**dass** der Auswerteeinheit durch die PV-Anlage und den Einstrahlungssensor zumindest zu einem gleichen Zeitpunkt ein der momentanen Einstrahlung entsprechender Leistungswert übermittelt wird, wobei durch die Auswerteeinheit ein Nominalwert N1 aus dem Verhältnis (Quotient) der beiden Leistungswerte gebildet wird, wobei bei Überoder Unterschreiten dieses zu einem bestimmten Zeitpunkt ermittelten Nominalwertes, durch den zum gleichen Zeitpunkt innerhalb eines bestimmten, nachgeordneten Zeitraumes ermittelten Nominalwertes N2 ein Signal, zum Beispiel eine Fehlermeldung durch die Auswerteeinheit generiert wird.

2. Vorrichtung zur Fehlerfeststellung einer Photovoltaikanlage mit einem photoelektrischen Einstrahlungssensor, wobei sowohl die Photovoltaikanlage (PV-Anlage), als auch der Einstrahlungssensor an einer Auswerteeinheit angeschlossen sind,
**dadurch gekennzeichnet,**
**dass** der Auswerteeinheit durch die PV-Anlage und den Einstrahlungssensor zumindest zu einem, vorzugsweise zu mehreren gleichen Zeitpunkten innerhalb eines bestimmten Zeitraumes ein der momentanen Einstrahlung entsprechender Leistungswert übermittelt wird, wobei durch die Auswerteeinheit ein Nominalwert N1 aus dem Verhältnis (Quotienten) der beiden Leistungswerte gebildet wird, wobei korrespondierend zu den jeweiligen Nominalwerten N1 zu gleichen Zeitpunkten innerhalb des gleichen, späteren Zeitraumes weitere Nominalwerte N2 ermittelt werden, wobei durch Mittelwertbildung aus den beiden Nominalwerten N1 und N2 ein korrigierter Nominalwert NK bestimmt wird, wobei bei Über- oder Unterschreiten dieser korrigierten Nominalwerte NK durch korrespondierend zu den Nominalwerten N2 zum jeweils gleichen Zeitpunkt innerhalb eines gleichen, späteren Zeitraumes ermittelten Nominalwerte N3 ein Signal, zum Beispiel eine Fehlermeldung, durch die Auswerteeinheit generiert wird.

3. Vorrichtung nach Anspruch 2,
**dadurch gekennzeichnet,**
**dass** durch Mittelwertbildung des jeweils letzten korrigierten Nominalwertes NK mit dem jeweils korrespondierenden neuen Nominalwert weitere korrigierte Nominalwerte NK1-n bestimmt werden.

4. Vorrichtung nach einem oder mehrerer der voranstehenden Ansprüche,
**dadurch gekennzeichnet,**
**dass** den über einen bestimmten Zeitraum ermittelten Nominalwerten ein Toleranzbereich zugeordnet wird.

5. Vorrichtung nach Anspruch 4,
**dadurch gekennzeichnet,**
**dass** der Toleranzbereich aus der Bandbreite bestimmt wird, in der ein bestimmter Prozentsatz von Nominalwerten sich befindet.

6. Vorrichtung nach einem oder mehrerer der voranstehenden Ansprüche,
**dadurch gekennzeichnet,**
**dass** der bzw. die Nominalwerte in einem Speicher der Auswerteeinheit abgelegt werden.

7. Vorrichtung nach einem oder mehrerer der voranstehenden Ansprüche,
**dadurch gekennzeichnet,**
**dass** die gemeinsame Temperatur sowohl der PV-Anlage als auch des Einstrahlungssensors ermittelt wird und notwendige Korrekturen durch die Auswerteeinheit durchgeführt werden.

8. Vorrichtung nach einem oder mehrerer der voranstehenden Ansprüche,
**dadurch gekennzeichnet,**
**dass** die Vorrichtung zur Fehlerfeststellung einer PV-Anlage mit einer Anzeige in Verbindung steht.

9. Vorrichtung nach einem oder mehrerer der voranstehenden
Ansprüche,
**dadurch gekennzeichnet,**
**dass** die Verbindungen der einzelnen Elemente (Einstrahlungssensor, Auswerteeinheit, Display) durch Funk erfolgt.

10. Vorrichtung nach einem oder mehrerer der voranstehenden Ansprüche,
**dadurch gekennzeichnet,**
**dass** ein Speicher zum Speichern der Nominalwerte der
Leistungswerte der PV-Anlage und/oder des Einstrahlungssensors vorgesehen ist.

11. Vorrichtung nach einem oder mehrerer der voranstehenden Ansprüche,
**dadurch gekennzeichnet,**
**dass** die Anzeige als Display ausgebildet ist.

12. Vorrichtung nach einem oder mehrerer der voranstehenden Ansprüche,
**dadurch gekennzeichnet,**
**dass** die Ermittlung der Leistungswerte der PV-Anlage an der Übergabestelle (am Einspeisezähler) erfolgt.
